# EUROPEAN PATENT SPECIFICATION

(11) **EP 0 455 322 B1**
(45) Date of publication and mention of the grant of the patent: **03.09.1997**
(21) Application number: 91301366.0
(22) Date of filing: 20.02.1991
(51) Int. Cl.: H01L 23/495, H01L 23/48

(54) **Semiconductor device**
Halbleiteranordnung
Dispositif semi-conducteur

(30) Priority: 23.02.1990 JP 43055/90; 30.03.1990 JP 84254/90
(43) Date of publication of application: 06.11.1991
(73) Proprietor: FUJI ELECTRIC CO. LTD., Kawasaki 210 (JP)
(72) Inventor: Furuhata, Shooichi, Matumoto (JP); Kobayashi, Susumu, Matumoto (JP)
(74) Representative: Carmichael, David Andrew Halliday

(56) References cited:
- DE-A- 3 734 067

## Description

The present invention relates to a semiconductor device that includes switching elements to control a current flowing between a pair of electrodes by means of signals given between an auxiliary electrode of the device and one of the main electrodes. Examples of such switching elements include power transistors, and power MOSFET or insulation gate bipolar transistors (IGBT).

DE-OS-37 34 067 discloses a semiconductor package wherein wire connection between the base and one of the main terminals and auxiliary terminals are made by attaching wires to the upstanding parts of the terminal strips. The upstanding parts are straight sections, and the connecting wires are intertwined.

Spurred by the recent demand for low-loss power switching elements, operational resistance of an element is reduced by means of a fine pattern formed on the surface of a semiconductor. This fine pattern achieves a reduction in operational resistance, and at the same time, enhances turn-on characteristics. However, especially in fields where electrical power is handled, a momentary current variation di/dt increases directly relative to the turn-on characteristics, and the increase in di/dt causes an increase in surge voltage corresponding to (L x di/dt) as a result of the interaction with the inductance, L, caused by the wiring in a semiconductor device. The surge voltage exceeds the rated voltage of the element and often causes element destruction. This problem is caused also from an increase in di/dt at off state because of improved turn-off characteristics.

The present invention will now be described in detail with reference to the accompanying drawings, in which:
Figures 1A, 1B and 1C show plan, side and front views, respectively, of a general arrangement of a conventional IGBT;
Figures 2A, 2B and 2C show plan, side and front views, respectively, of an IGBT used in conventional semiconductor devices;
Figure 3 is a circuit diagram of the IGBT of Figures 2A, 2B and 2C;
Figure 4 is a circuit diagram of the IGBT of Figures 1A, 1B and 1C;
Figure 5 is a circuit diagram of one phase of a three-phase inverter circuit used in one embodiment of the present invention;
Figure 6 is an exploded perspective view illustrating the package composition of the semiconductor device shown in the equivalent circuit diagram in Figure 5;
Figures 7A, 7B and 7C are perspective views of three alternative designs for the main emitter terminal according to different embodiments of the invention; and
Figure 8 is an illustration of a conventional semiconductor device using conduction pattern inductance.

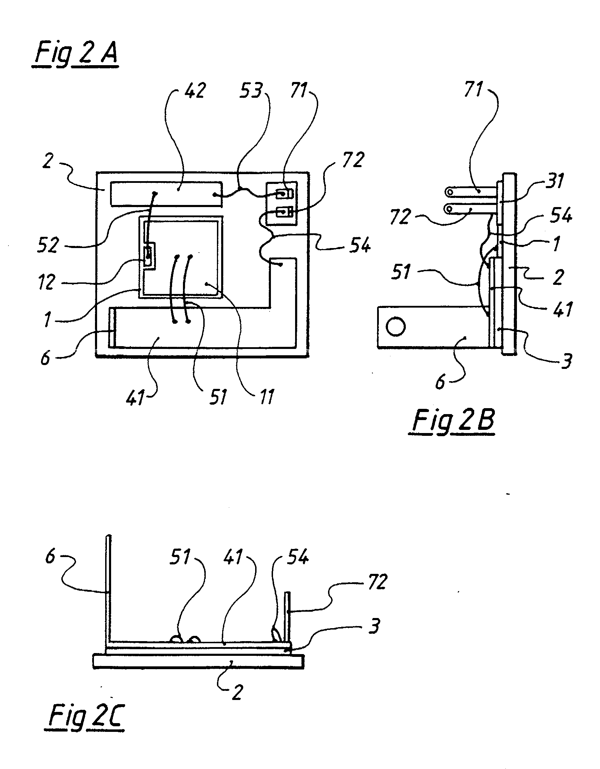

To connect a main electrode or an auxiliary electrode formed on the surface of one semiconductor to an external circuit, each electrode is conventionally connected to a lead-out terminal via a conductor plate that is insulated and fixed on the same support plate as the semiconductor piece. The electrode and the conductor plate are connected by an ordinary lead wire, and the conductor plate and the draw-out terminal are connected either by linking the draw-out terminal directly to the conductor plate or by means of a lead wire. Figures 2A, 2B and 2C show a prior art example of an IGBT semiconductor piece 1 fixed to a metal support plate 2 by means of a collector electrode beneath the semiconductor piece. On the surface of the metal support plate 2, a first conductor strip 41 is fixed via an insulating plate 3, and a second conductor strip 42 is fixed via a further insulating plate (not shown). An emitter electrode 11 on top of the semiconductor piece 1 is connected to the first conductor strip 41, and gate electrode 12 is connected to the second conductor strip 42, by lead wires 51 and 52 respectively. One end of the first conductor strip 41 is raised to form a main emitter terminal 6. Moreover, auxiliary terminals 71 and 72 are fixed to the support plate 2 by means of an insulating plate 31. The auxiliary terminal 71 is connected to the second conductor strip 42 by a lead wire 53, thereby forming a gate terminal, and the auxiliary terminal 72 is connected to the first conductor strip 41 by a lead wire 54, thereby forming an auxiliary emitter terminal.

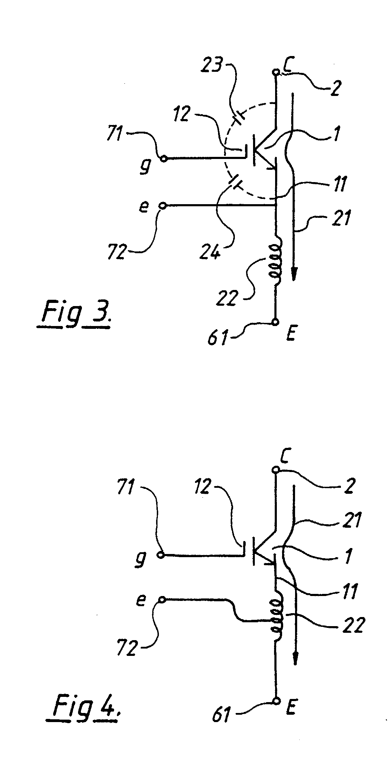

Figure 3 shows a circuit diagram of the prior art semiconductor device shown in Figures 2A, 2B and 2C. The same numerals are given to corresponding parts in Figures 2A, 2B, 2C and Figure 3. When a positive voltage is applied to the gate terminal 71 and a negative voltage is applied to the auxiliary emitter terminal 72, the IGBT element 1 begins to turn on. At this time, the collector current 21 is exactly proportional to the voltage across terminals 71 and 72. However, if the response speed of the element 1 is too fast, the collector current 21 rises excessively. As a result, the surge voltage produced by the product of the main electrode wiring inductance 22 and di/dt becomes excessive when the element 1 is turned off. To prevent this a resistance is connected in series to the gate terminal 71, and a voltage is applied between the gate electrode 12 and the emitter electrode 11 of the element 1 so slowly that it is determined by a time constant defined by the parasitic capacities 23 and 24 of the resistance and the element. This arrangement prevents the collector current from changing excessively upon start-up and shutdown. However, there is a drawback in that the delay time before the voltage reaches across the gate is too long, and the emitter voltage required for. the collector current 21 to start flowing into the element 1 is too great. Moreover, the delay time across the gate and emitter causes the voltage to drop too much upon shutdown.

The objective of the present invention is to provide a semiconductor device that prevents damage to elements caused by the surge voltages that are caused by the internal wiring board upon start-up or shutdown in the case where a switching element that has a fast turn-on/turn-off response speed is included. At the same time, this invention circumvents the excessive delay time at start-up or shutdown.

According to the present invention, there is provided a semiconductor device mounted on a planar metal support plate comprising;
a semiconductor switching device having a first main electrode arranged on a first face, and a second main electrode and a control electrode arranged on its second face, wherein the semiconductor device is fixed to the metal support plate by means of its first main electrode;
a main terminal and first and second auxiliary terminals mounted to the support plate but electrically insulated therefrom, each of the main and auxiliary terminals having a conductor strip extending parallel to the plane of the support plate and an upstanding part extending perpendicularly to the plane of the support plate, the control electrode being electrically connected by a wire to the conductor strip of the first auxiliary terminal, the conductor strip of the main terminal being connected to the second main electrode by a wire, wherein the application of a control voltage between the first and second auxiliary terminals allowing current to flow between the first and second main electrodes.
and characterised in that the upstanding part of the main terminal comprises first and second portions extending perpendicularly to the plane of the support plate, the first portion being attached to the conductor strip, said first and second portions being connected by two, four or six right-angled bends, and in that the main terminal is connected to the second auxiliary terminal by a wire attached to the second portion of the main terminal.

The wire controls the main current by applying a voltage across the first and second auxiliary terminals.

The operation of the device will now be described. While the main current of the semiconductor flows in the wires connecting the main electrode to the main terminal, the circuit from the main electrode to the second auxiliary terminal also goes through most of the connecting wires. Therefore, the counter electromotive voltage generated by the main current and the inductance of the wiring to the main electrode is also applied between the first and second auxiliary terminals, thereby slowly increasing and decreasing the control voltage applied between the first and second auxiliary terminals. Thus, the surge voltage generated by a change in the main current, and the connecting wiring inductance, is suppressed.

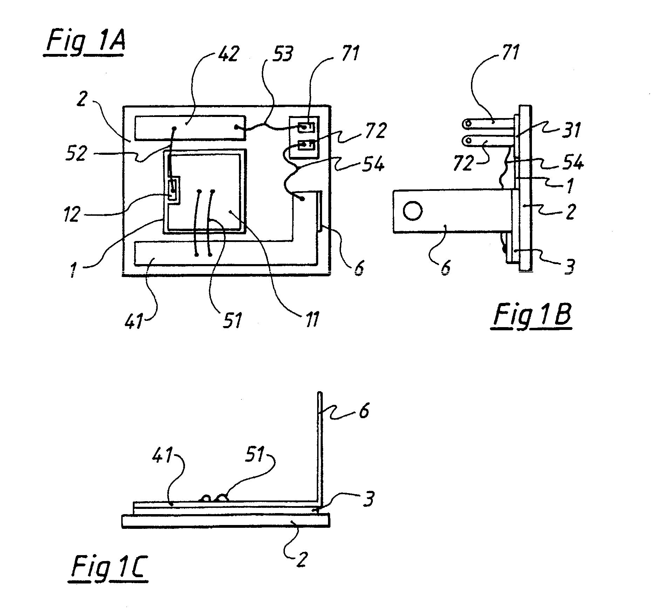

Referring again to the drawings, Figures 1A, 1B and 1C show a conventional IGBT arrangement, with the same reference numbers given to parts common to Figures 1A, 1B, 1C and Figures 2A, 2B, 2C. The emitter electrode 11 on top of the IGBT semiconductor piece 1 fixed on the metal support plate 2 by the collector electrode is connected to the first conductor strip 41 by the lead wire 51, and the gate electrode 12 is connected to the second conductor strip 42 by the lead wire 52, similar to the arrangement seen in Figures 2A, 2B and 2C. Also, as in Figures 2A, 2B and 2C, the terminal 71 rising from the support plate 2 and mounted on an insulating plate 31, and the auxiliary emitter terminal 72 are connected respectively to the conductor strips 41 and 42 by the lead wires 53 and 54. However, the upstanding part of the main emitter terminal 6 is located at the end of the first conductor strip 41 proximate to the auxiliary terminal 72, and provides the location for the connection point with the lead wire 54. When shown as a circuit diagram it is as in Figure 4. Figure 4 uses the same reference numerals for parts corresponding to those of Figures 1A, 1B and 1C. In other words, the connection point of the auxiliary emitter terminal 72 with the IGBT element 1 is placed in a position opposite to the element of the wiring inductance 22 in the lead wire 51 and the first conductor strip 41. By this arrangement, the counter electromotive force generated by the main electrode wiring inductance 22 of more than 20 nH and the collector current 21 reacts on the voltage applied between the "g" terminal 71 and the "e" terminal 72, to suppress the rise rate of the voltage between the gate electrode 12 and the emitter electrode 11 of the element 1. Even if a voltage with a fast rise rate is applied between the "g" and "e" terminals 71 and 72, the voltage between the gate and emitter electrodes 12 and 11 of the element slows down as its rise rate receives an effect from the counter electromotive voltage generated by the wiring inductance 22 and the collector current 21; and in proportion with it, the rise rate di/dt of the collector current 21 also slows down. Further, a reverse action when it is turned off slows down the voltage between the element electrodes 12 and 11 which attempt to disconnect rapidly, thus preventing a rapid decrease in the collector current 21.

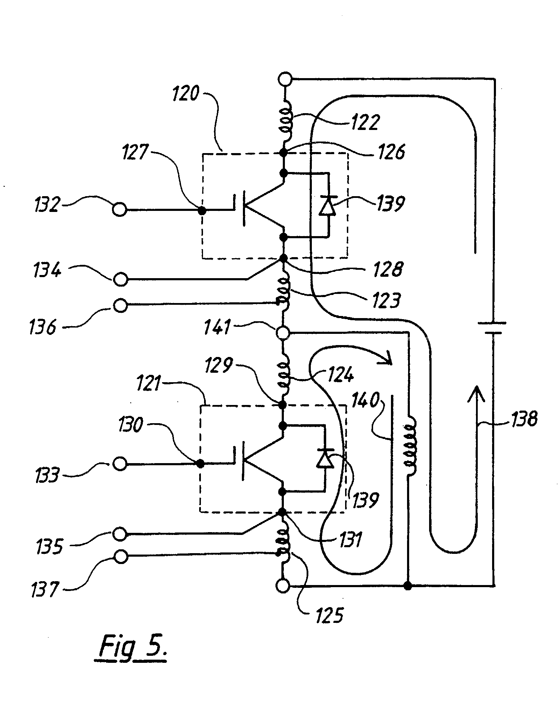

An embodiment of the present invention is explained by referring to Figures 5 to 7. Figure 5 shows a circuit diagram of one phase of a three-phase inverter circuit. In Figure 5, when IGBT elements 120 and 121 are housed in a container, inductances 122 to 125 comprising package components are inserted equivalently. The electrodes for each of the IGBT elements 120 and 121 are connected to each part constituting the semiconductor device at positions 126 to 131, while 132 and 133 refer to gate terminals, and 134 and 135 are auxiliary emitter terminals, being the conventional case in which they are remote from the vicinity of the semiconductor elements. Parts 136 and 137 are the lead-out positions according to the present invention.

Operation of this equivalent circuit starts when a positive signal is given to the gate terminal 132 of the upper element 120, and a negative signal is given to the auxiliary emitter terminal 134. The counter electromotive force generated at this time between the main current IC 138 and the inductance 123 will not act on the area between the gate terminal 132 and the auxiliary emitter terminal 134. Therefore, the main current IC 138 rises rapidly in proportion to the signal given to the gate terminal. At this time, the lower element 121 is in an off state, and a diode 139, which has been sending a return current 140, goes rapidly to an off state, hence an excessive surge current is generated at the collectors of element 121. Then, element 121 may misfire because of a parasitic capacity Cge between the gate and the emitter, and a steep dv/dt, which may lead to a short circuit between the upper and lower arms.

Utilising the teaching of the invention, if the auxiliary emitter terminal is removed to position 136, the counter electromotive voltage generated between the main current IC 138 and the inductance 123 will suppress the rise rate of the signal given between the gate and the emitter, whereby the rise of the main current IC is slowed down, and the surge voltage is less likely to generate. Additionally, when turned off, the reverse takes place, allowing the main current IC to reduce more slowly, and an overvoltage becomes less likely to happen.

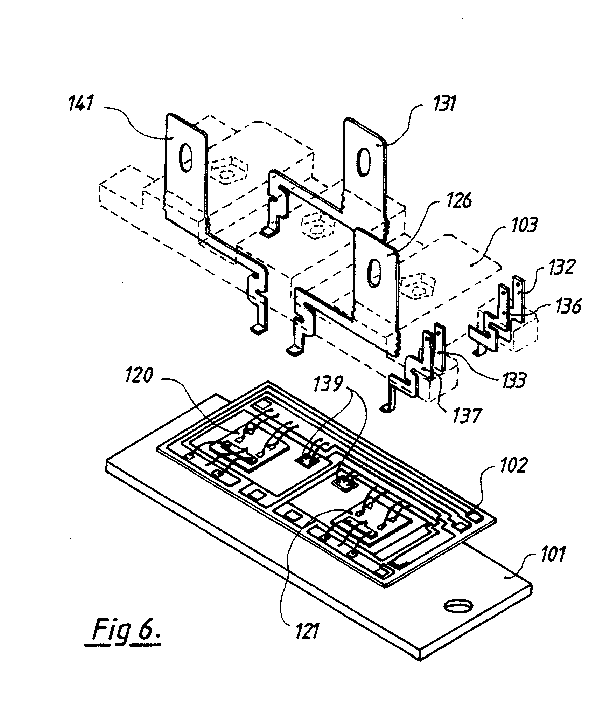

Figure 6 is an exploded perspective view showing the package structure of a semiconductor device as shown by the equivalent circuit in Figure 5.

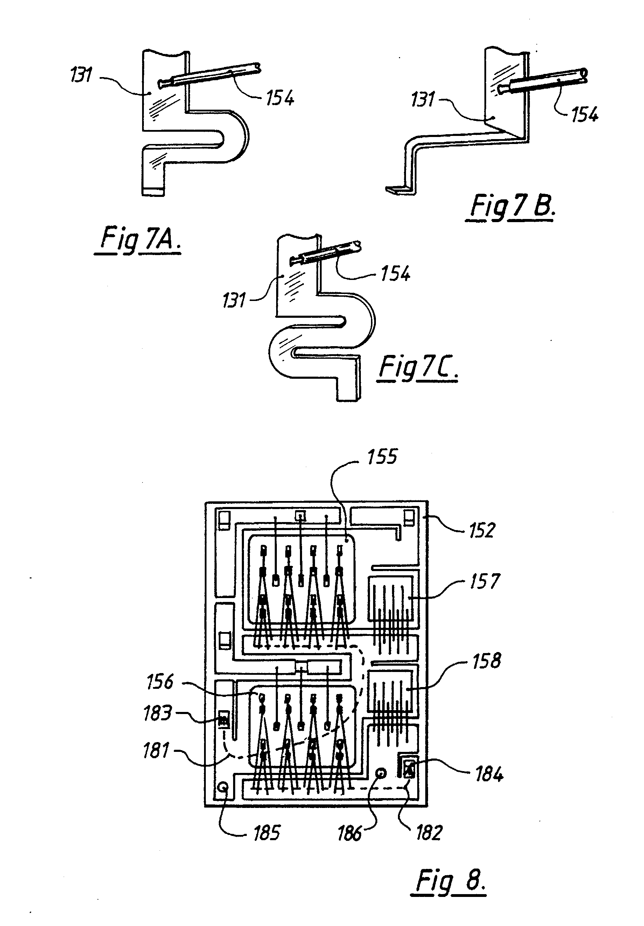

In Figure 6, the IGBT elements 120 and 121, and diode element 139 are fixed on the metal supporting plate 102. The current flows through the circuit pattern, and is led to an external circuit by the main terminals 126, 131, 141 held on a package component 103, and the auxiliary terminals 132, 133, 136, 137. Part 101 is a base to fix the metal supporting plate 102. Next, an explanation is given of the configuration of the main emitter terminal 131, with reference to Figure 7. Figures 7A to 7C are partially expanded drawings of the main emitter terminal 131 according to different embodiments of the invention. As shown in Figures 7A, 7B and 7C, an attempt is made to optimise the wiring inductance by means of changing the position of the connecting wire fixing to the auxiliary emitter terminal, and changing the shape of the main emitter terminal.

An semiconductor device utilising the inductance of a conduction pattern is shown in Figure 8. Parts 155 and 156 are IGBT elements, and 157 and 158 are diode elements. The main currents 181 and 182 flow through the conduction pattern formed on a circuit constituting component 152, and are led to the main terminal from positions 183 and 184. The take-out position of auxiliary terminals 185 and 186 shall be in the vicinity of the main terminais 183 and 184 that utilise inductance of the conduction pattern.

While the embodiments using IGBT have been explained above, it is clear that other switching elements will generate equivalent effects.

The rapid rise or attenuation of the control voltage can be suppressed, and a generation of the excessive surge voltage can be prevented by the counter electromotive voltage generated from the main electrode connecting wiring when it is turned on or turned off, by placing the upstanding portion of the main terminal from the wiring connected to the main electrode of a switching element closer to the position of connection between the main terminal conductor and the auxiliary terminal. It was proved that an effect can be obtained to prevent the elements from an overvoltage destruction. Moreover, the time when the main current starts flowing when turned on, and the time when the main current starts to decrease when turned off, are not delayed.

## Claims

1. A semiconductor device mounted on a planar metal support plate (102) comprising;
a semiconductor switching device (120) having a first main electrode arranged on a first face, and a second main electrode and a control electrode arranged on its second face, wherein the semiconductor device is fixed to the metal support plate by means of its first main electrode;
a main terminal (131) and first (132) and second (136) auxiliary terminals mounted to the support plate but electrically insulated therefrom, each of the main and auxiliary terminals having a conductor strip extending parallel to the plane of the support plate and an upstanding part extending perpendicularly to the plane of the support plate, the control electrode being electrically connected by a wire to the conductor strip of the first auxiliary terminal (132), the conductor strip of the main terminal (131), being connected to the second main electrode by a wire, wherein the application of a control voltage between the first and second auxiliary terminals (132,136) allows current to flow between the first and second main electrodes
and characterised in that the upstanding part of the main terminal (131) comprises first and second portions extending perpendicularly to the plane of the support plate (102), the first portion being attached to the conductor strip, said first and second portions being connected by two, four or six right-angled bends, and in that the main terminal (131) is connected to the second auxiliary terminal (136) by a wire (154) attached to the second portion of the main terminal (131).

## Revendications

1. Dispositif à semi-conducteurs monté sur une plaque de support métallique plane (102), comportant i
un dispositif de commutation à semi-conducteurs (120) ayant une première électrode principale agencée sur une première face, et une seconde électrode principale et une électrode de commande agencée sur sa seconde face, le dispositif à semi-conducteurs étant fixé sur la plaque de support métallique par l'intermédiaire de sa première électrode principale,
une borne principale (131) et une première (132) et une seconde (136) borne auxiliaire montées sur la plaque de support mais isolées électriquement de celle-ci, chacune des bornes principale et auxiliaires ayant une bande conductrice s'étendant parallèlement au plan de la plaque de support et une partie dirigée vers le haut s'étendant perpendiculairement au plan de la plaque de support, l'électrode de commande étant connectée électriquement par un fil à la bande conductrice de la première borne auxiliaire (132), la bande conductrice de la borne principale (131) étant connectée à la seconde électrode principale par un fil, l'application d'une tension de commande entre la première et la seconde borne auxiliaire (132, 136) permettant au courant de s'écouler entre la première et la seconde électrode principale,
et caractérisé en ce que la partie s'étendant vers le haut de la borne principale (131) comporte une première et une seconde partie s'étendant perpendiculairement au plan de la plaque de support (102), la première partie étant fixée sur la bande conductrice, lesdites première et seconde parties étant liées par deux, quatre ou six coudes à angle droit, et en ce que la borne principale (131) est connectée à la seconde borne auxiliaire (136) par un fil (154) fixé sur la seconde partie de la borne principale (131).

## Patentansprüche

1. Halbleiteranordnung, die auf einer ebenen Metallhalteplatte (102) befestigt ist, mit:
einer Halbleiterschaltungsanordnung (120), die eine auf einer erste Fläche angeordnete erste Hauptelektrode und eine zweite Hauptelektrode und Steuerelektrode, die auf ihrer zweiten Fläche angeordnet ist, aufweist, worin die Halbleiteranordnung an der Metallhalteplatte mittels ihrer ersten Hauptelektrode befestigt ist;
einem Hauptanschluß (131) und ersten (132) und zweiten (136) Hilfsanschlüssen, die an der Halteplatte befestigt, aber von dieser elektrisch isoliert sind, wobei - jeder der Haupt- und Hilfsanschlüsse einen Leiterstreifen, der sich parallel zur Ebene der Halteplatte erstreckt, und einen hochstehenden Teil, der sich senkrecht zur Ebene der Halteplatte erstreckt, aufweist, die Steuerelektrode elektrisch durch eine Leitung mit dem Leiterstreifen des ersten Hilfsanschlusses (132) verbunden ist, der Leiterstreifen des Hauptanschlusses (131) mit der zweiten Hauptelektrode durch eine Leitung verbunden ist, worin das Anlegen einer Steuerspannung zwischen den ersten und zweiten Hilfsanschlüsse (132,136) gestattet, daß Strom zwischen den ersten und zweiten Hauptelektroden fließt
und dadurch gekennzeichnet, daß der hochstehende Teil des Hauptanschlusses (131) erste und zweite Abschnitte aufweist, die sich senkrecht zur Ebene der Halteplatte (102) erstrecken, wobei der erste Abschnitt an dem Leiterstreifen angebracht ist, die ersten und zweiten Abschnitte durch zwei, vier, oder sechs rechtwinklige Winkelstücke verbunden sind, und dadurch, daß der Hauptanschluß (131) mit dem zweiten Hilfsanschluß (136) durch eine Leitung (154) verbunden ist, die an den zweiten Abschnitt des Hauptanschlusses (131) befestigt ist.
